# EUROPEAN PATENT APPLICATION

(11) **EP 4 507 470 A1**
(43) Date of publication of application: **12.02.2025**
(21) Application number: 22936572.1
(22) Date of filing: 08.04.2022
(51) Int. Cl.: H05K 13/04, H05K 3/12, H05K 3/32

(54) **ELECTRICAL CIRCUIT FORMATION METHOD AND ELECTRICAL CIRCUIT FORMATION DEVICE**

(71) Applicant: Fuji Corporation, Chiryu-shi, Aichi 472-8686 (JP)
(72) Inventor: SAKAKIBARA, Ryo, Chiryu-shi, Aichi 472-8686 (JP)
(74) Representative: Grünecker Patent- und Rechtsanwälte PartG mbB
(86) International application number: PCT/JP2022/017408
(87) International publication number: WO 2023/195175

(57) **Abstract**

There is provided an electrical circuit formation method including: a fluid application step of applying a conductive fluid to a planned mounting position of an electrode of an electronic component on a metal wiring line formed on a resin layer; a mounting step of mounting the electronic component such that the electrode comes into contact with the conductive fluid; and a pressing step of pressing the electronic component mounted in the mounting step relative to the resin layer by a pressing member in a state in which a sheet including a surface with a coefficient of friction lower than a coefficient of friction of at least a part of a surface of the pressing member that faces the electronic component is sandwiched between the electronic component and the pressing member.

## Description

### Technical Field

The present invention relates to an electrical circuit formation method of applying a conductive fluid onto a metal wiring line formed on a resin layer, mounting an electronic component such that an electrode comes into contact with the conductive fluid, and then pressing the electronic component relative to the resin layer, and the like.

### Background Art

Patent Literature 1 below describes a technique of forming an electrical circuit by using a three-dimensional shaping device.

### Patent Literature

Patent Literature 1: WO2019/102522

### Summary of the Invention

### Technical Problem

When an electrical circuit is formed by a three-dimensional shaping device, an electronic component may be mounted to be electrically connected to a metal wiring line, and the electronic component may be pressed by a pressing member. An object of the present invention is to appropriately ensure an electrical connection between the electronic component and the metal wiring line in such a case.

### Solution to Problem

In order to achieve the above object, the present description discloses an electrical circuit formation method that includes: a fluid application step of applying a conductive fluid to a planned mounting position of an electrode of an electronic component on a metal wiring line formed on a resin layer; a mounting step of mounting the electronic component such that the electrode comes into contact with the conductive fluid; and a pressing step of pressing the electronic component mounted in the mounting step relative to the resin layer by a pressing member in a state in which a sheet including a surface with a coefficient of friction lower than a coefficient of friction of at least a part of a surface of the pressing member that faces the electronic component is sandwiched between the electronic component and the pressing member.

The present description also discloses an electrical circuit formation device that includes: an application device configured to apply a conductive fluid to a planned mounting position of an electrode of an electronic component on a metal wiring line formed on a resin layer; a mounting device configured to mount the electronic component such that the electrode comes into contact with the conductive fluid; and a pressing device configured to press the electronic component mounted by the mounting device relative to the resin layer by a pressing member in a state in which a sheet including a surface with a coefficient of friction lower than a coefficient of friction of at least a part of a surface of the pressing member that faces the electronic component is sandwiched between the electronic component and the pressing member.

### Advantageous Effect of the Invention

In the present disclosure, the conductive fluid is applied onto the metal wiring line formed on the resin layer, the electronic component is mounted such that the electrode comes into contact with the conductive fluid, and then, the electronic component is pressed by the pressing member in a state in which the sheet is sandwiched between the electronic component and the pressing member. The sheet includes the surface with a coefficient of friction lower than a coefficient of friction of at least a part of the surface of the pressing member that faces the electronic component. As a result, it is possible to appropriately ensure the electrical connection between the electronic component and the metal wiring line when the electronic component is pressed by the pressing member.

### Brief Description of Drawings

Fig. 1 is a diagram illustrating a circuit formation device.
Fig. 2 is a block diagram illustrating a control device.
Fig. 3 is a cross-sectional view illustrating a circuit board in a state in which a resin laminate is formed.
Fig. 4 is a cross-sectional view illustrating the circuit board in a state in which a wiring line is formed on the resin laminate.
Fig. 5 is a cross-sectional view illustrating the circuit board in a state in which a resin laminate is further formed on the resin laminate.
Fig. 6 is a cross-sectional view illustrating the circuit board in a state in which a conductive paste is applied onto the wiring line.
Fig. 7 is a cross-sectional view illustrating the circuit board in a state in which a thermosetting resin is applied onto a resin layer.
Fig. 8 is a cross-sectional view illustrating the circuit board in a state in which an electronic component is mounted.
Fig. 9 is a cross-sectional view illustrating the circuit board in a state in which the electronic component is pressed toward the resin laminate.
Fig. 10 is a cross-sectional view illustrating the circuit board in a state in which the thermosetting resin is applied around the electronic component.
Fig. 11 is a diagram illustrating a pressurizing unit in a state in which two resin sheets are suspended.
Fig. 12 is a cross-sectional view illustrating the circuit board in a state in which the electronic component is pressed toward the resin laminate by a rubber plate in a state in which the resin sheet is sandwiched between the electronic component and the rubber plate.

### Description of Embodiments

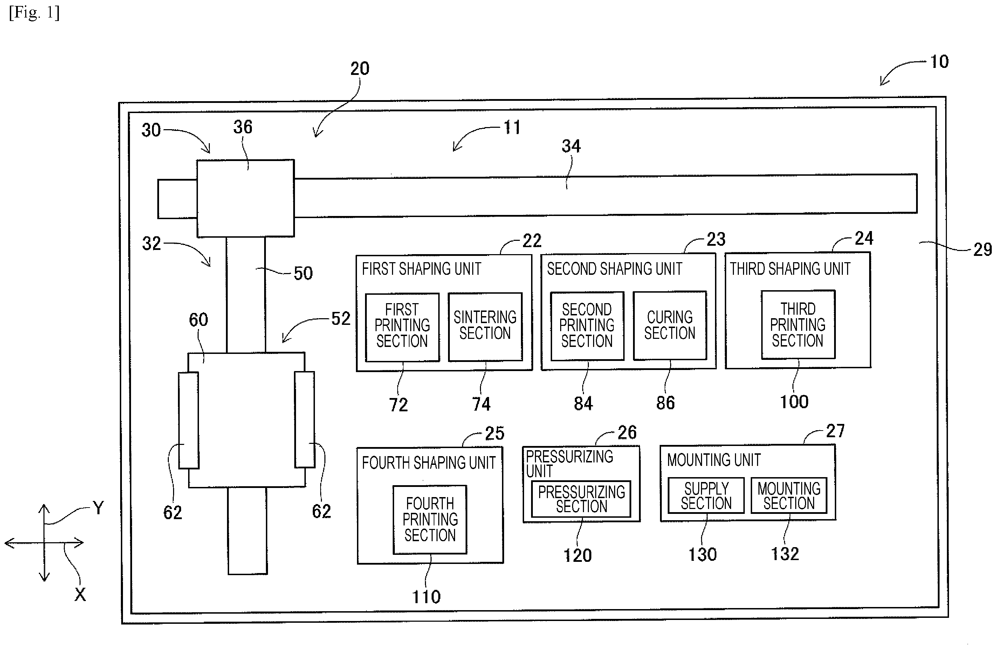

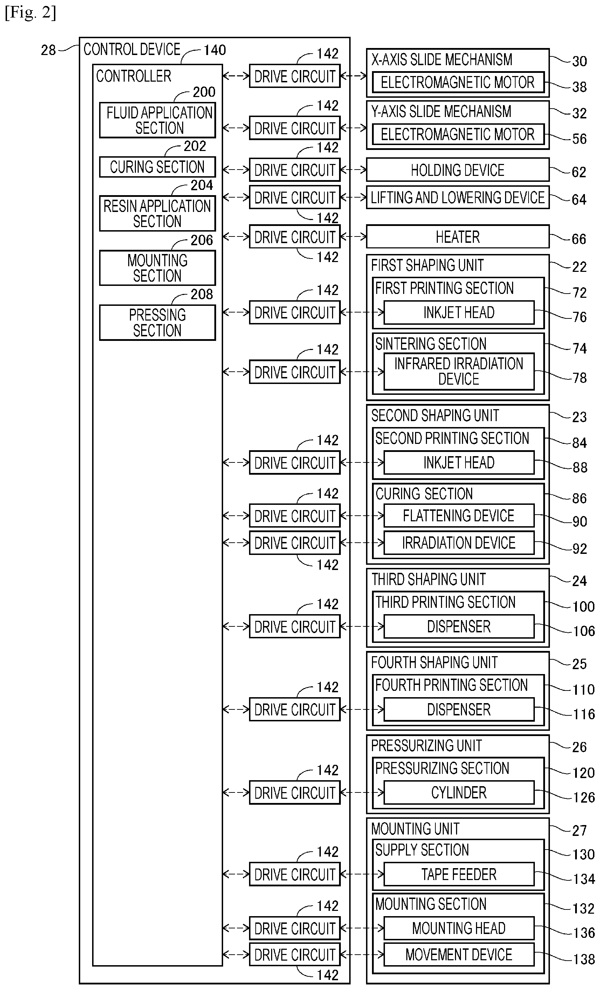

Fig. 1 illustrates circuit formation device 10. Circuit formation device 10 includes conveyance device 20, first shaping unit 22, second shaping unit 23, third shaping unit 24, fourth shaping unit 25, pressurizing unit 26, mounting unit 27, and control device (refer to Fig. 2) 28. Conveyance device 20, first shaping unit 22, second shaping unit 23, third shaping unit 24, fourth shaping unit 25, pressurizing unit 26, and mounting unit 27 are disposed on base 29 of circuit formation device 10. Base 29 is generally rectangular in shape, and in the following description, a longitudinal direction of base 29 will be referred to as an X-axis direction, a transverse direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held on X-axis slide rail 34 to be slidable in the X-axis direction. Further, X-axis slide mechanism 30 includes electromagnetic motor (refer to Fig. 2) 38, and X-axis slider 36 moves to any position in the X-axis direction by the drive of electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end part of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor (refer to Fig. 2) 56, and stage 52 moves to any position in the Y-axis direction by the drive of electromagnetic motor 56. As a result, stage 52 moves to any position on base 29 by the drive of X-axis slide mechanism 30 and Y-axis slide mechanism 32.

Stage 52 includes base plate 60, holding device 62, lifting and lowering device (refer to Fig. 2) 64, and heater (refer to Fig. 2) 66. Base plate 60 is formed in a flat plate shape, and a board is placed on an upper surface thereof. Holding device 62 is provided on both side parts of base plate 60 in the X-axis direction. Both edge parts of the board placed on base plate 60 in the X-axis direction are sandwiched by holding device 62, thereby fixedly holding the board. In addition, lifting and lowering device 64 is disposed below base plate 60 to lift and lower base plate 60. Further, heater 66 is incorporated into base plate 60 and heats the board placed on base plate 60 to any temperature.

First shaping unit 22 is a unit that shapes a wiring line of a circuit board, and includes first printing section 72 and sintering section 74. First printing section 72 includes inkjet head (refer to Fig. 2) 76, and inkjet head 76 linearly ejects metal ink. The metal ink is metal ink in which nanometer-sized metal fine particles, for example, silver fine particles, are dispersed in a solvent. Surfaces of the metal fine particles are coated with a dispersant to prevent aggregation in the solvent. Additionally, inkjet head 76 ejects the metal ink from multiple nozzles through, for example, a piezoelectric method using a piezoelectric element.

Sintering section 74 includes infrared irradiation device (refer to Fig. 2) 78. Infrared irradiation device 78 is a device that irradiates the ejected metal ink with infrared rays. The metal ink irradiated with the infrared rays is subjected to sintering, thereby forming the wiring line. Sintering of the metal ink is a phenomenon in which applying energy causes the solvent to evaporate, the protective films of the metal fine particles, that is, the dispersant, to break down, or the like so that the metal fine particles come into contact with or fuse each other, thereby increasing the conductivity. The metal ink is subjected to sintering, thereby forming a wiring line made of metal.

In addition, second shaping unit 23 is a unit that shapes a resin layer of the circuit board, and includes second printing section 84 and curing section 86. Second printing section 84 includes inkjet head (refer to Fig. 2) 88, and inkjet head 88 ejects an ultraviolet curable resin. The ultraviolet curable resin is a resin to be cured by irradiation with ultraviolet rays. Inkjet head 88 may employ, for example, a piezoelectric method using a piezoelectric element or a thermal method of heating a resin to generate air bubbles and ejecting the air bubbles from multiple nozzles.

Curing section 86 includes flattening device (refer to Fig. 2) 90 and irradiation device (refer to Fig. 2) 92. Flattening device 90 flattens an upper surface of the ultraviolet curable resin ejected by inkjet head 88, and makes the thickness of the ultraviolet curable resin uniform by, for example, evening out the surface of the ultraviolet curable resin while scraping off an excess resin with a roller or a blade. Additionally, irradiation device 92 includes a mercury lamp or an LED as a light source and irradiates the ejected ultraviolet curable resin with ultraviolet rays. As a result, the ejected ultraviolet curable resin is cured, thereby forming the resin layer.

Third shaping unit 24 is a unit that shapes a connection section between the electrode of the electronic component and the wiring line on the circuit board, and includes third printing section 100. Third printing section 100 includes dispenser (refer to Fig. 2) 106, and dispenser 106 ejects conductive paste. The conductive paste is a conductive paste in which micrometer-sized metal particles are dispersed in a resin to be cured by relatively low-temperature heating. Incidentally, the metal particles have a flake shape, and viscosity of the conductive paste is relatively higher compared to that of the metal ink. The ejection amount of the conductive paste by dispenser 106 is controlled based on an inner diameter of a needle or a pressure during ejection, and an ejection time.

The conductive paste ejected by dispenser 106 is heated by heater 66 incorporated into base plate 60. In the heated conductive paste, the resin is cured. At this time, in the conductive paste, the resin is cured and contracted, and the dispersed flake-shaped metal particles come into contact with the resin. Consequently, the conductive paste exhibits conductivity. Additionally, the resin in the conductive paste is an organic adhesive and exhibits an adhesive strength when cured by heating.

Fourth shaping unit 25 is a unit that shapes a resin for fixing the electronic component to the circuit board, and includes fourth printing section 110. Fourth printing section 110 includes dispenser (refer to Fig. 2) 116, and dispenser 116 ejects a thermosetting resin. The thermosetting resin is a resin to be cured by heating. Dispenser 116 employs, for example, a piezoelectric method using a piezoelectric element. The thermosetting resin ejected from dispenser 116 is heated by heater 66 incorporated into base plate 60 and is cured.

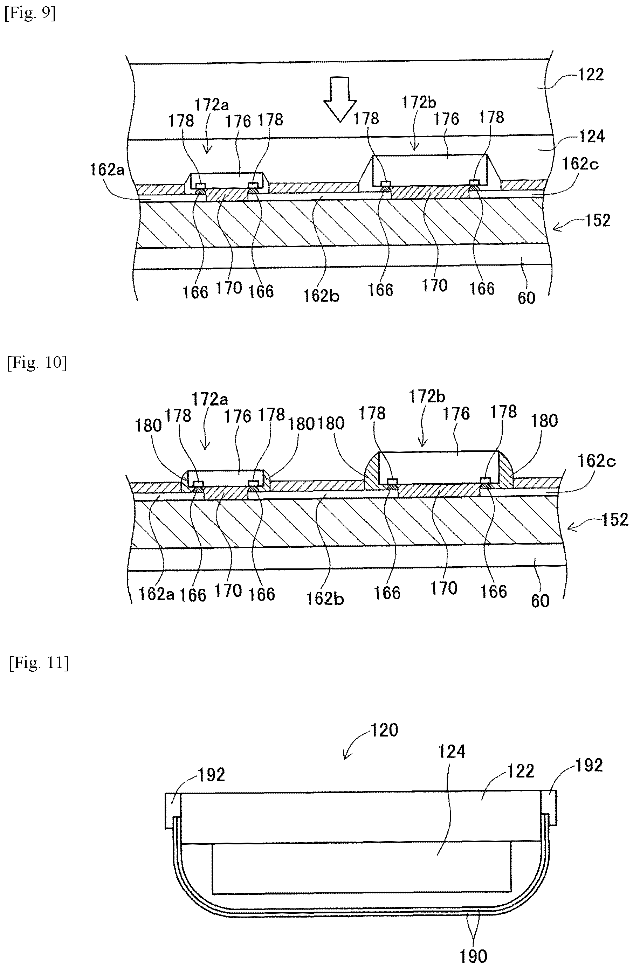

In addition, pressurizing unit 26 is a unit for pressurizing the circuit board, and includes pressurizing section 120. Pressurizing section 120 includes pressurizing plate (refer to Fig. 9) 122, rubber plate (refer to Fig. 9) 124, and cylinder (refer to Fig. 2) 126. Rubber plate 124 is formed of, for example, silicone rubber and has a plate shape. Further, pressurizing plate 122 is formed of, for example, steel material and has a plate shape. Rubber plate 124 is bonded to a lower surface of pressurizing plate 122, and pressurizing plate 122 is pressed toward the circuit board by the operation of cylinder 126. Consequently, the circuit board is pressurized by pressurizing plate 122 via rubber plate 124. By controlling the operation of cylinder 126, it is possible to controllably change the pressurizing force applied to the board.

Additionally, mounting unit 27 is a unit that mounts the electronic component on the circuit board, and includes supply section 130 and mounting section 132. Supply section 130 includes multiple tape feeders (refer to Fig. 2) 134 that feed taped electronic components one by one, and supplies the electronic component at a supply position. Supply section 130 is not limited to tape feeder 134 and may be a tray type supply device that supplies the electronic component by picking up the electronic component from a tray. Alternatively, supply section 130 may include both the tape type supply device and the tray type supply device, or other supply devices.

Mounting section 132 includes mounting head (refer to Fig. 2) 136 and movement device (refer to Fig. 2) 138. Mounting head 136 includes a suction nozzle (not illustrated) for picking up and holding the electronic component. The suction nozzle picks up and holds the electronic component by suctioning air through the supply of a negative pressure from a positive and negative pressure supply device (not illustrated). By supplying a slight positive pressure from the positive and negative pressure supply device, the electronic component is released. Additionally, movement device 138 moves mounting head 136 between the supply position of the electronic component by tape feeder 134 and the board placed on base plate 60. Consequently, in mounting section 132, the electronic component supplied from tape feeder 134 is held by the suction nozzle, and the electronic component held by the suction nozzle is mounted on the board.

In addition, control device 28 includes controller 140 and multiple drive circuits 142, as illustrated in Fig. 2. Multiple drive circuits 142 are connected to electromagnetic motors 38 and 56, holding device 62, lifting and lowering device 64, heater 66, inkjet head 76, infrared irradiation device 78, inkjet head 88, flattening device 90, irradiation device 92, dispenser 106, dispenser 116, cylinder 126, tape feeder 134, mounting head 136, and movement device 138 described above. Controller 140 includes CPU, ROM, RAM, and the like, is mainly configured as a computer, and is connected to multiple drive circuits 142. As a result, the operations of conveyance device 20, first shaping unit 22, second shaping unit 23, third shaping unit 24, fourth shaping unit 25, pressurizing unit 26, and mounting unit 27 are controlled by controller 140.

With the configuration described above, in circuit formation device 10, a resin laminate is formed on base plate 60, and a wiring line is formed on an upper surface of the resin laminate. The electrode of the electronic component is electrically connected to the wiring line via the conductive paste, and the electronic component is fixed by the resin, thereby forming the circuit board.

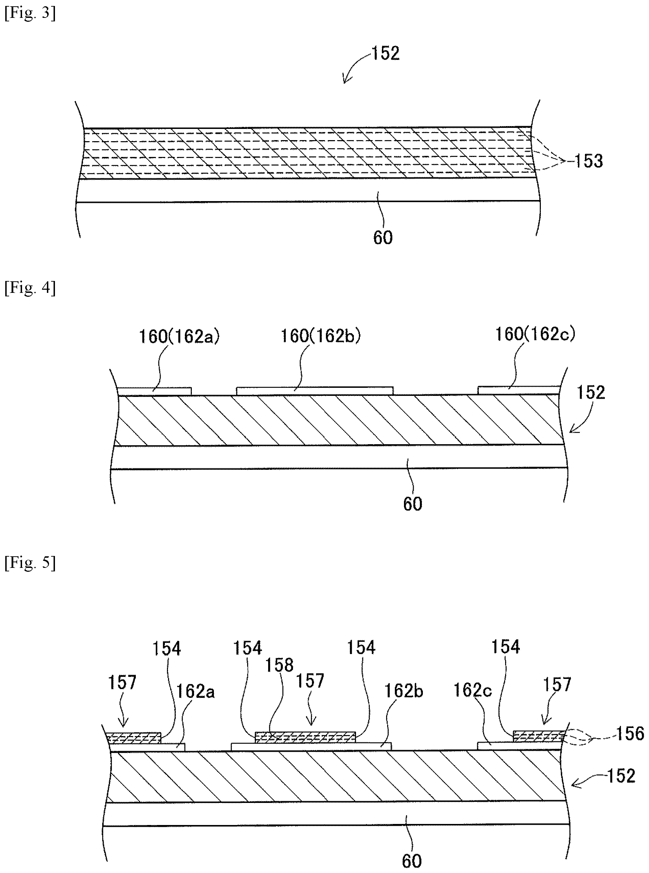

Specifically, first, stage 52 is moved below second shaping unit 23. Then, in second shaping unit 23, as illustrated in Fig. 3, resin laminate 152 is formed on base plate 60 of stage 52. Resin laminate 152 is formed by repeatedly ejecting the ultraviolet curable resin from inkjet head 88 and irradiating the ejected ultraviolet curable resin with ultraviolet rays from irradiation device 92.

In detail, in second printing section 84 of second shaping unit 23, inkjet head 88 ejects the ultraviolet curable resin in a thin film shape onto the upper surface of base plate 60. Subsequently, when the ultraviolet curable resin is ejected in a thin film shape, in curing section 86, the ultraviolet curable resin is flattened by flattening device 90 such that the ultraviolet curable resin has a uniform film thickness. Then, irradiation device 92 irradiates the thin film-shaped ultraviolet curable resin with ultraviolet rays. As a result, thin film-shaped resin layer 153 is formed on base plate 60.

Subsequently, inkjet head 88 ejects the ultraviolet curable resin in a thin film shape onto thin film-shaped resin layer 153. The thin film-shaped ultraviolet curable resin is flattened by flattening device 90, irradiation device 92 irradiates the ultraviolet curable resin ejected in a thin film shape with ultraviolet rays, thereby laminating thin film-shaped resin layer 153 on thin film-shaped resin layer 153. In this manner, by repeatedly ejecting the ultraviolet curable resin onto thin film-shaped resin layer 153 and irradiating the ultraviolet curable resin with ultraviolet rays and by laminating multiple resin layers 153, resin laminate 152 is formed.

Next, when resin laminate 152 is formed, stage 52 is moved below first shaping unit 22. Then, in first printing section 72 of first shaping unit 22, as illustrated in Fig. 4, inkjet head 76 linearly ejects metal ink 160 on an upper surface of resin laminate 152 in accordance with a circuit pattern. Subsequently, infrared irradiation device 78 irradiates metal ink 160 ejected in accordance with the circuit pattern with infrared rays in sintering section 74 of first shaping unit 22. Consequently, metal ink 160 is subjected to sintering, thereby forming wiring line 162 on the upper surface of resin laminate 152. In Fig. 4, three wiring lines 162 are formed, but in a case where three wiring lines 162 are distinguished from each other, the wiring line on the left side in Fig. 4 will be described as wiring line 162a, the wiring line at the center will be described as wiring line 162b, and the wiring line on the right side will be described as wiring line 162c.

Subsequently, when wiring line 162 is formed on resin laminate 152, stage 52 is moved below second shaping unit 23. Then, in second shaping unit 23, inkjet head 88 ejects the ultraviolet curable resin in a thin film shape such that end parts of three wiring lines 162 are exposed. Subsequently, when the ultraviolet curable resin is ejected in a thin film shape, in curing section 86, the ultraviolet curable resin is flattened such that the ultraviolet curable resin has a uniform film thickness. Then, irradiation device 92 irradiates the thin film-shaped ultraviolet curable resin with ultraviolet rays. As a result, as illustrated in Fig. 5, resin layer 156 is formed on resin laminate 152.

Subsequently, inkjet head 88 ejects the ultraviolet curable resin in a thin film shape only onto a portion on resin layer 156. That is, inkjet head 88 ejects the ultraviolet curable resin in a thin film shape onto resin layer 156 such that the end parts of three wiring lines 162 are exposed. The thin film-shaped ultraviolet curable resin is flattened by flattening device 90, and irradiation device 92 irradiates the ultraviolet curable resin ejected in a thin film shape with ultraviolet rays, thereby laminating resin layer 156 on resin layer 156. In this manner, by repeatedly ejecting the ultraviolet curable resin onto resin layer 156 and irradiating the ultraviolet curable resin with ultraviolet rays and by laminating multiple resin layers 156, resin laminate 157 is formed. As a result, resin laminate 157 is formed on resin laminate 152, and a step portion between resin laminate 152 and resin laminate 157 functions as cavity 154.

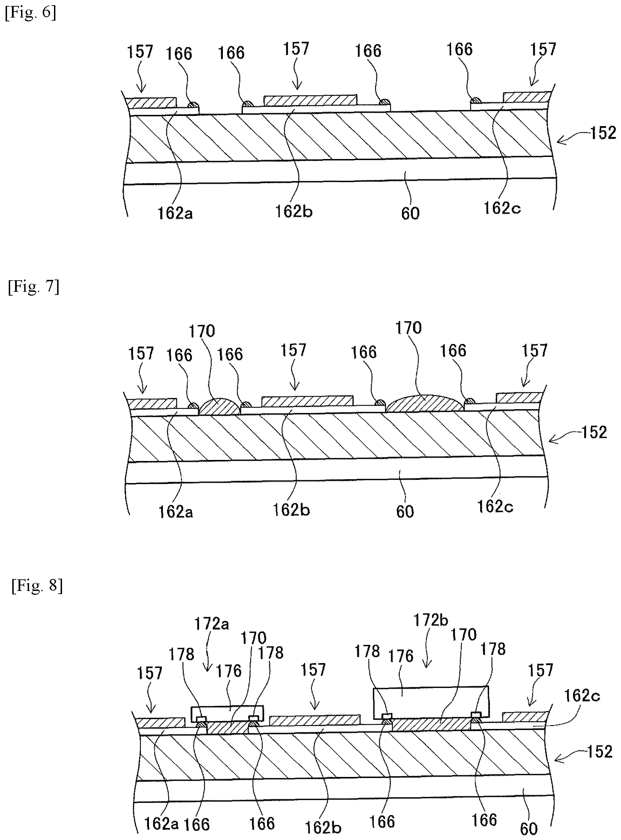

When resin laminate 157 is formed on resin laminate 152 in this manner, stage 52 is moved below third shaping unit 24. In third printing section 100 of third shaping unit 24, as illustrated in Fig. 6, dispenser 106 ejects conductive paste 166 onto both end parts of wiring line 162b, and onto end parts of wiring line 162a and wiring line 162c that face both end parts of wiring line 162b.

When conductive paste 166 is ejected onto the end part of wiring line 162 in this manner, resin laminate 152 is heated by heater 66 incorporated into base plate 60 in accordance with a heating condition of the conductive paste. Consequently, conductive paste 166 is heated and cured via resin laminate 152. The heating condition of the conductive paste is a heating condition for completely curing the conductive paste and is set by the manufacturer of the production source of the conductive paste. In addition, the heating condition of the conductive paste is set in accordance with a result of heating the conductive paste experimentally performed by a user of the conductive paste. In this manner, conductive paste 166 is heated in accordance with the heating condition of the conductive paste and completely cured, thereby exhibiting conductivity.

When conductive paste 166 ejected onto the end part of wiring line 162 is cured by heating in this manner, stage 52 is moved below fourth shaping unit 25. In fourth printing section 110 of fourth shaping unit 25, as illustrated in Fig. 7, dispenser 116 ejects thermosetting resin 170 onto the upper surface of resin laminate 152 between the end parts of two wiring lines 162a and 162b that face each other and ejects thermosetting resin 170 onto the upper surface of resin laminate 152 between the end parts of two wiring lines 162b and 162c that face each other.

Then, when thermosetting resin 170 is ejected onto the upper surface of resin laminate 152 between the end parts of two wiring lines 162 that face each other, stage 52 is moved below mounting unit 27. In mounting unit 27, electronic component (refer to Fig. 8) 172 is supplied by tape feeder 134, and electronic component 172 is held by the suction nozzle of mounting head 136. Electronic component 172 includes component body 176 and two electrodes 178 disposed on a lower surface of component body 176. Mounting head 136 is moved by movement device 138, and electronic component 172 held by the suction nozzle is mounted on the upper surface of resin laminate 152 as illustrated in Fig. 8. In Fig. 8, two electronic components 172 are mounted on the upper surface of resin laminate 152, and two electronic components 172 are different in size. Therefore, a small-sized electronic component will be described as electronic component 172a, and a large-sized electronic component will be described as electronic component 172b. Two electronic components 172a and 172b are mounted on the upper surface of resin laminate 152 such that electronic component 172a is electrically connected to two wiring lines 162a and 162b and electronic component 172b is electrically connected to two wiring lines 162b and 162c.

Specifically, electronic component 172a is mounted such that electrode 178 comes into contact with conductive paste 166, which has been cured on wiring lines 162a and 162b. At this time, component body 176 of electronic component 172a comes into contact with thermosetting resin 170 ejected between wiring lines 162a and 162b. Additionally, electronic component 172b is mounted such that electrode 178 comes into contact with conductive paste 166, which has been cured on wiring lines 162b and 162c. At this time, component body 176 of electronic component 172b comes into contact with thermosetting resin 170 ejected between wiring lines 162b and 162c. That is, conductive paste 166 is ejected to a planned mounting position of electrode 178 on wiring line 162, and thermosetting resin 170 is ejected to a planned mounting position of component body 176. Therefore, when electronic component 172 is mounted on resin laminate 152, electrode 178 comes into contact with conductive paste 166, which has been cured on wiring line 162, and component body 176 comes into contact with thermosetting resin 170. Further, thermosetting resin 170, which is in contact with component body 176, is enclosed between component body 176 and resin laminate 152. That is, thermosetting resin 170 is enclosed between the upper surface of resin laminate 152 and the lower surface of component body 176. The ejection amount of thermosetting resin 170 by dispenser 116 is controlled such that thermosetting resin 170 does not protrude from between the upper surface of resin laminate 152 and the lower surface of component body 176.

In this manner, by mounting two electronic components 172a and 172b, electronic component 172a is electrically connected to two wiring lines 162a and 162b, and electronic component 172b is electrically connected to two wiring lines 162b and 162c. However, since electronic component 172 is mounted such that electrode 178 comes into contact with conductive paste 166 that has been cured, a contact area between electrode 178 and conductive paste 166 is small at this point in time. Meanwhile, although component body 176 of electronic component 172 comes into contact with thermosetting resin 170, the contact area between component body 176 and thermosetting resin 170 increases because thermosetting resin 170 is uncured at this point in time.

When electronic component 172 is mounted on the upper surface of resin laminate 152 in this manner, stage 52 is moved below pressurizing unit 26. Then, in pressurizing section 120 of pressurizing unit 26, as illustrated in Fig. 9, electronic component 172 mounted on resin laminate 152 is pressed downward from above by pressurizing plate 122 via rubber plate 124. Two electronic components 172a and 172b are mounted on resin laminate 152, and two electronic components 172 have different sizes. Additionally, the two electronic components have different height dimensions. However, since rubber plate 124 is bonded to the lower surface of pressurizing plate 122, rubber plate 124 is elastically deformed when two electronic components 172 are pressurized, so that two electronic components 172 having different height dimensions can be appropriately pressed.

Further, when the electronic component is pressurized in pressurizing unit 26, resin laminate 152 is heated by heater 66 incorporated into base plate 60. Consequently, thermosetting resin 170 is heated and cured via resin laminate 152. Here, the heating temperature is, for example, a temperature (for example, 85°C) at which thermosetting resin 170 is cured. That is, thermosetting resin 170 enclosed between the upper surface of resin laminate 152 and the lower surface of component body 176 is cured while being pressurized by rubber plate 124. Consequently, the contact area between component body 176 and thermosetting resin 170 further increases, and electronic component 172 is fixed to the upper surface of resin laminate 152 at component body 176 by the adhesive strength of thermosetting resin 170. In addition, when electronic component 172 is pressurized, that is, when electronic component 172 mounted on resin laminate 152 is pressed toward resin laminate 152, conductive paste 166 in contact with electrode 178 of electronic component 172 is deformed, and the contact area between electrode 178 and conductive paste 166 increases. As a result, the electrical connection between electronic component 172 and wiring line 162 is ensured.

When the pressurizing in pressurizing unit 26 is completed, stage 52 is moved below fourth shaping unit 25. Then, in fourth printing section 110 of fourth shaping unit 25, dispenser 116 ejects thermosetting resin 180 around electronic component 172 to cover a side surface of component body 176 of electronic component 172, as illustrated in Fig. 10. Then, resin laminate 152 is heated by heater 66 incorporated into base plate 60. Consequently, thermosetting resin 180 is heated and cured via resin laminate 152. Here, the heating temperature is, for example, a temperature (for example, 85°C) at which thermosetting resin 180 is cured. Consequently, thermosetting resin 180 is cured while covering the side surface of component body 176. That is, in electronic component 172 mounted on resin laminate 152, thermosetting resins 170 and 180 are enclosed between the upper surface of resin laminate 152 and the lower surface of component body 176 and are cured while covering the side surface of component body 176. As a result, electronic component 172 mounted on the upper surface of resin laminate 152 is fixed by the cured resin.

In this manner, electronic component 172 mounted on the upper surface of resin laminate 152 is fixed by the cured resin, thereby forming the circuit board. However, when the circuit board is formed, as described above, electronic component 172 mounted on resin laminate 152 is pressurized by rubber plate 124 in a state in which resin laminate 152 is heated, which may lead to deformation in rubber plate 124 due to thermal expansion caused by heating. When the electronic component is pressed downward by deformed rubber plate 124, the pressing force of rubber plate 124 may not be directed straight downward but be directed diagonally downward. In such a case, since the electronic component is pressed not only downward but also in a left-right direction, the electronic component mounted on resin laminate 152 may be displaced in the left-right direction, which may cause the electrode of the electronic component to be separated from conductive paste 166. That is, the conductivity between wiring line 162 and electrode 178 of electronic component 172 may not be appropriately ensured during the pressurizing work of the electronic component by rubber plate 124.

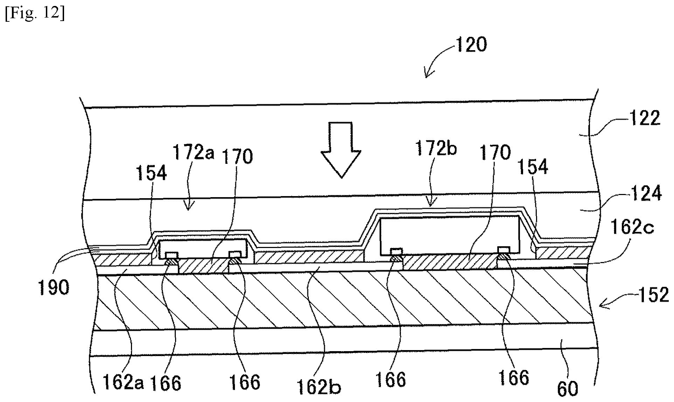

In view of the above, electronic component 172 is pressed toward resin laminate 152 by rubber plate 124 in a state in which two resin sheets (refer to Fig. 12) 190 are stacked and sandwiched between rubber plate 124 and electronic component 172 during the pressurizing work of the electronic component. Specifically, two resin sheets 190 have substantially the same dimension, and the external dimension of each resin sheet 190 is larger than the external dimension of pressurizing plate 122. As illustrated in Fig. 11, two resin sheets 190 are preemptively attached to pressurizing plate 122 in pressurizing section 120. In detail, two resin sheets 190 are fixed to a pair of opposing side surfaces of pressurizing plate 122 by fixtures 192 at a pair of opposing edge parts of each resin sheet 190 in a stacked state. Two resin sheets 190 are suspended below rubber plate 124 in a sagging state and cover the entirety of the lower surface of rubber plate 124. That is, two resin sheets 190 are disposed below rubber plate 124 without tension and cover the entirety of the lower surface of rubber plate 124.

Two resin sheets 190 are formed of the same material and are formed of a material having a low coefficient of friction, such as polytetrafluoroethylene (PTFE), fluororesin, ultra-high molecular weight polyethylene, or MC nylon (registered trademark), that is, a material having good slip properties. Therefore, both sides of resin sheet 190 have low coefficients of friction, and the coefficient of friction of each of both sides of resin sheet 190 is lower than the coefficient of friction of the lower surface of rubber plate 124. In addition, as the material of resin sheet 190, a material having high heat resistance and high release properties is employed. Since resin laminate 152 is heated during the pressurizing work of the electronic component, a heat-resistant material having a heat resistant temperature equal to or higher than the heating temperature (for example, 85°C) of thermosetting resins 170 and 180 is employed as the material of resin sheet 190. Further, considering that thermosetting resin 170 inserted between the electronic component and resin laminate 152 adheres to resin sheet 190 during the pressurizing work of the electronic component, a material that exhibits high release from thermosetting resin 170 is employed as the material of resin sheet 190. Furthermore, resin sheet 190 is a thin sheet, and the thickness dimension of resin sheet 190 is several tens of µm to several hundreds of µm (specifically, for example, 50 µm).

Such two resin sheets 190 are attached to pressurizing section 120, and in pressurizing section 120, as illustrated in Fig. 12, electronic component 172 mounted on resin laminate 152 is pressurized by rubber plate 124. That is, electronic component 172 is pressed toward resin laminate 152 by rubber plate 124 in a state in which two resin sheets 190 are stacked and sandwiched between rubber plate 124 and electronic component 172. At this time, even when the electronic component is pressed by rubber plate 124, and the pressing force of rubber plate 124 is not directed straight downward but diagonally downward, two resin sheets 190 can relatively slide in the left-right direction by the pressing force of rubber plate 124 directed diagonally downward. That is, two resin sheets 190, which are stacked and sandwiched between rubber plate 124 and electronic component 172, can relatively slide in the left-right direction on the contact surfaces thereof by the pressing force of rubber plate 124 directed diagonally downward. Therefore, since the pressing force of rubber plate 124 directed diagonally downward is hardly or not transmitted to electronic component 172 at all, it is possible to reduce the displacement of the electronic component mounted on resin laminate 152 in the XY directions. As a result, the conductivity between wiring line 162 and electrode 178 of electronic component 172 can be appropriately ensured during the pressurizing work of the electronic component by rubber plate 124.

Additionally, since resin sheet 190 is formed of a heat resistant material having a heat resistant temperature equal to or higher than the heating temperature (for example, 85°C) of thermosetting resins 170 and 180, resin sheet 190 is prevented from being melted during the heating and pressurizing. Further, resin sheet 190 is formed of a material that exhibits high release from thermosetting resin 170. Therefore, even when thermosetting resin 170 enclosed between the electronic component and resin laminate 152 adheres to resin sheet 190 during the pressurizing work of the electronic component, resin sheet 190 can be easily peeled off from the electronic component after the pressurizing work of the electronic component. Furthermore, since resin sheet 190 is a thin sheet, resin sheet 190 is suitably deformed together with rubber plate 124 during the pressurizing work of the electronic component. That is, when rubber plate 124 is deformed in accordance with a dimensional difference or the like of the electronic components during the pressurizing work of the electronic component, resin sheet 190 is suitably deformed to follow rubber plate 124. As a result, it is possible to appropriately prevent the electronic component from being displaced in the left-right direction between the electronic component and rubber plate 124.

In addition, as illustrated in Fig. 2, controller 140 of control device 28 includes fluid application section 200, curing section 202, resin application section 204, mounting section 206, and pressing section 208. Fluid application section 200 is a functional section for applying conductive paste 166 to the planned mounting position of electrode 178 of electronic component 172 on wiring line 162. Curing section 202 is a functional section for curing conductive paste 166 applied in fluid application section 200. Resin application section 204 is a functional section for applying thermosetting resin 170 to come into contact with component body 176 of electronic component 172. Mounting section 206 is a functional section for mounting electronic component 172 such that electrode 178 comes into contact with conductive paste 166 and component body 176 comes into contact with thermosetting resin 170. Pressing section 208 is a functional section for pressing rubber plate 124 toward resin laminate 152 in a state in which two resin sheets 190 are stacked and sandwiched between electronic component 172 and rubber plate 124.

In the above example, circuit formation device 10 is an example of an electrical circuit formation device. Pressurizing unit 26 is an example of a pressing device. Dispenser 106 is an example of an application device. Rubber plate 124 is an example of a pressing member. Mounting head 136 is an example of a mounting device. Resin laminate 152 is an example of a resin layer. Wiring line 162 is an example of a metal wiring line. Conductive paste 166 is an example of a conductive fluid. Thermosetting resin 170 is an example of a curable resin. Electronic component 172 is an example of an electronic component. Component body 176 is an example of a component body. Electrode 178 is an example of an electrode. Resin sheet 190 is an example of a sheet. Additionally, a step executed by fluid application section 200 is an example of a fluid application step. A step executed by curing section 202 is an example of a curing step. A step executed by resin application section 204 is an example of a resin application step. A step executed by mounting section 206 is an example of a mounting step. A step executed by pressing section 208 is an example of a pressing step.

The present invention is not limited to the above example and can be performed in various aspects in which various modifications and improvements are made based on the knowledge of those skilled in the art. For example, in the above example, two resin sheets 190 are sandwiched in a stacked state between electronic component 172 and rubber plate 124, but three or more resin sheets 190 may be sandwiched in a stacked state. Alternatively, one resin sheet 190 may be folded to overlap, and one resin sheet 190 may be sandwiched between electronic component 172 and rubber plate 124 in a folded state. Meanwhile, one resin sheet 190 may be sandwiched between electronic component 172 and rubber plate 124 without being folded. Even when one resin sheet 190 is sandwiched between electronic component 172 and rubber plate 124 without being folded, resin sheet 190 and the electronic component relatively slide in the left-right direction. As a result, it is possible to suppress displacement of electronic component 172 mounted on resin laminate 152 in the left-right direction, thereby appropriately ensuring the conductivity between wiring line 162 and electrode 178 of electronic component 172.

Further, in the above example, resin sheet 190 having good slip properties is employed, but a resin sheet having poor slip properties can also be employed as long as it is a surface-treated resin sheet. Specifically, as long as a surface of a sheet using a material such as polyethylene terephthalate (PET) is coated with a silicone-based or non-silicone-based release agent or the like, the sheet can be employed as the resin sheet of the present invention. When the surface of the sheet is coated with the release agent, both sides of the sheet may be coated with the release agent, or only one side of the sheet may be coated with the release agent. However, in a case where only one side of the sheet is coated with the release agent, it is necessary to coat a contact surface, where the sheets are in close contact with each other, with the release agent when multiple sheets are stacked. That is, for example, when two sheets are stacked, the lower surface of the sheet placed on the upper side of the two sheets is coated with the release agent, and the upper surface of the sheet placed on the lower side of the two sheets is coated with the release agent. However, when three or more sheets are stacked, the lower surface of the uppermost sheet is coated with the release agent, the upper surface of the lowermost sheet is coated with the release agent, and both sides of the remaining sheets are coated with the release agent.

In addition, in the above example, resin sheet 190 is employed, but sheets made of various materials can be employed as long as the sheet includes a surface with a coefficient of friction lower than the lower surface of rubber plate 124. For example, a sheet made of paper, metal, or the like can be employed, and when the coefficient of friction of the surface of the sheet is not low, the surface of the sheet need only be coated with the release agent or the like.

Further, in the above example, two resin sheets 190 are suspended below rubber plate 124, first resin sheet 190 may be bonded to the lower surface of rubber plate 124, and second resin sheet 190 may be suspended below rubber plate 124.

Additionally, in the above example, resin sheet 190 is preemptively fixed to pressurizing plate 122 and is suspended below rubber plate 124, but resin sheet 190 may be disposed by an operator between rubber plate 124 and electronic component 172 before rubber plate 124 descends. Alternatively, resin sheet 190 may be automatically disposed between rubber plate 124 and electronic component 172 by a device such as a robot hand. When resin sheet 190 is disposed between rubber plate 124 and electronic component 172 before rubber plate 124 descends in this manner, resin sheet 190 is not fixed to pressurizing plate 122, rubber plate 124, or the like.

In addition, in the above example, since rubber plate 124 functioning as the pressing member is formed of one material, the coefficient of friction of the surface of rubber plate 124 that faces the electronic component is uniformly the same. On the other hand, in the pressing member formed of multiple materials, the coefficient of friction of the surface of the pressing member that faces the electronic component may be different for each part. In such a case, resin sheet 190 need only include a surface with a coefficient of friction lower than at least a part of the surface of the pressing member that faces the electronic component.

Further, in the above example, electronic component 172 is pressed toward resin laminate 152 by rubber plate 124 when rubber plate 124 descends, but electronic component 172 may be pressed toward resin laminate 152 by rubber plate 124 when stage 52 ascends. Alternatively, when rubber plate 124 descends and stage 52 ascends, electronic component 172 may be pressed toward resin laminate 152 by rubber plate 124.

Additionally, in the above example, thermosetting resin 170 is ejected to the planned mounting position of component body 176 of electronic component 172 before electronic component 172 is mounted on resin laminate 152, but thermosetting resin 170 may be ejected onto resin laminate 152 after electronic component 172 is mounted on resin laminate 152. At this time, thermosetting resin 170 is ejected between the lower surface of component body 176 of electronic component 172 mounted on resin laminate 152 and the upper surface of resin laminate 152. Then, after thermosetting resin 170 is ejected between the lower surface of component body 176 of electronic component 172 and the upper surface of resin laminate 152, electronic component 172 is pressurized by rubber plate 124 in pressurizing unit 26.

Further, in the above example, electronic component 172 is mounted in a state in which conductive paste 166 is completely cured, and electronic component 172 is pressurized by rubber plate 124. Meanwhile, electronic component 172 may be mounted in a state in which conductive paste 166 is semi-cured, and electronic component 172 may be pressurized by rubber plate 124. Alternatively, electronic component 172 may be mounted in a state in which conductive paste 166 is neither semi-cured nor completely cured, and electronic component 172 may be pressurized by rubber plate 124. When electronic component 172 is mounted in a state in which conductive paste 166 is semi-cured and in a state in which conductive paste 166 is neither semi-cured nor completely cured, and electronic component 172 is pressurized by rubber plate 124, the conductive paste is completely cured by heating by heater 66.

In addition, in the above example, electronic component 172 is pressurized by rubber plate 124 in a state in which thermosetting resin 170 is ejected between the lower surface of component body 176 of electronic component 172 and the upper surface of resin laminate 152. Meanwhile, electronic component 172 may be pressurized by rubber plate 124 in a state in which thermosetting resin 170 is not ejected between the lower surface of component body 176 of electronic component 172 and the upper surface of resin laminate 152. That is, electrode 178 is in contact with conductive paste 166 cured on wiring line 162, but electronic component 172 may be pressurized by rubber plate 124 in a state in which nothing is in contact with component body 176. Consequently, the contact area between conductive paste 166 and electrode 178 can be increased. For example, after electronic component 172 is pressurized by rubber plate 124, thermosetting resin 170 may be ejected between the lower surface of component body 176 of electronic component 172 and the upper surface of resin laminate 152. As a result, electronic component 172 can be fixed to resin laminate 152.

Further, in the above example, conductive paste 166 is employed as the conductive fluid for electrically connecting wiring line 162 and electrode 178 of electronic component 172, but various fluids can be employed as long as the fluid exhibits conductivity.

Additionally, in the above embodiment, the thermosetting resin is employed as the curable resin for fixing electronic component 172 to resin laminate 152, but an ultraviolet curable resin, a two-liquid mixed curable resin, a thermoplastic resin, and the like can be formed. Further, in the above example, the ultraviolet curable resin is employed as the resin for forming resin laminate 152, and the thermosetting resin is employed as the resin for fixing electronic component 172. That is, the resin for forming resin laminate 152 and the resin for fixing electronic component 172 are different curable resins, but the resin for forming resin laminate 152 and the resin for fixing electronic component 172 may be the same curable resin.

In addition, in the above example, the conductive paste is ejected by dispenser 106, but the conductive paste may be transferred by a transfer device or the like. Alternatively, the conductive paste may be printed through screen printing.

### Reference Signs List

10: Circuit formation device (electrical circuit formation device), 26: Pressurizing unit (pressing device), 106: Dispenser (application device), 124: Rubber plate (pressing member), 136: Mounting head (mounting device), 152: Resin laminate (resin layer), 162: Wiring line (metal wiring line), 166: Conductive paste (conductive fluid), 170: Thermosetting resin (curable resin), 172: Electronic component, 176: Component body, 178: Electrode, 190: Resin sheet (sheet), 200: Fluid application section (fluid application step), 202: Curing section (curing step), 204: Resin application section (resin application step), 206: Mounting section (mounting step), 208: Pressing section (pressing step).

## Claims

1. An electrical circuit formation method comprising:
a fluid application step of applying a conductive fluid to a planned mounting position of an electrode of an electronic component on a metal wiring line formed on a resin layer;
a mounting step of mounting the electronic component such that the electrode comes into contact with the conductive fluid; and
a pressing step of pressing the electronic component mounted in the mounting step relative to the resin layer by a pressing member in a state in which a sheet including a surface with a coefficient of friction lower than a coefficient of friction of at least a part of a surface of the pressing member that faces the electronic component is sandwiched between the electronic component and the pressing member.

2. The electrical circuit formation method according to claim 1, wherein
in the pressing step, the electronic component mounted in the mounting step is pressed relative to the resin layer by the pressing member in a state in which a plurality of the sheets are stacked and sandwiched between the electronic component and the pressing member.

3. The electrical circuit formation method according to claim 1, further comprising:
a resin application step of applying a curable resin onto the resin layer to come into contact with a component body of the electronic component, the resin application step being provided before the pressing step.

4. The electrical circuit formation method according to claim 2, further comprising:
a resin application step of applying a curable resin onto the resin layer to come into contact with a component body of the electronic component, the resin application step being provided before the pressing step.

5. The electrical circuit formation method according to any one of claims 1 to 4, further comprising:
a curing step of curing the conductive fluid applied in the fluid application step.

6. An electrical circuit formation device comprising:
an application device configured to apply a conductive fluid to a planned mounting position of an electrode of an electronic component on a metal wiring line formed on a resin layer;
a mounting device configured to mount the electronic component such that the electrode comes into contact with the conductive fluid; and
a pressing device configured to press the electronic component mounted by the mounting device relative to the resin layer by a pressing member in a state in which a sheet including a surface with a coefficient of friction lower than a coefficient of friction of at least a part of a surface of the pressing member that faces the electronic component is sandwiched between the electronic component and the pressing member.
